# EUROPEAN PATENT APPLICATION

(11) **EP 2 894 030 A1**
(43) Date of publication of application: **15.07.2015**
(21) Application number: 13835012.9
(22) Date of filing: 26.08.2013
(51) Int. Cl.: B32B 15/04, B32B 9/00

(54) **LAMINATED BODY**

(30) Priority: 05.09.2012 JP 2012194802
(71) Applicant: Toray Industries, Inc., Tokyo, 103-8666 (JP)
(72) Inventor: TANI Satoru, Otsu-shi Shiga 520-8558 (JP); KOTOURA Masaaki, Otsu-shi Shiga 520-8558 (JP)
(74) Representative: Kador & Partner
(86) International application number: PCT/JP2013/072737
(87) International publication number: WO 2014/038424

(57) **Abstract**

This laminated body is formed by laminating, in the following order, a base material (A), a carbon layer (B) having a carbon element as a main component, and a metal layer (C) having a copper element as a main component. For instance, the base material (A) is formed of a metal plate, and the carbon layer (B) is formed of an amorphous carbon layer having a thickness of 0.005-10 µm. The laminated body, which can be suitably used for the purpose of forming an electrode metal to be used in electronic apparatuses, and which has the metal layer to be the electrode easily formed on a circuit board by means of a transfer method, is provided with excellent cost performance.

## Description

### Technical Field

The present invention relates to a laminate that can be suitably used in forming metal parts of an electrode for electronic devices and also relates to a technique that can easily form a metal electrode layer on a circuit board by a transfer method.

### Background Art

Various electronic devices contain various multi-layer printed wiring boards and various electrode production methods are known to serve for manufacturing small and high performance electronic devices. Among them are some well-known methods that use a process of transferring a circuit pattern formed by, for example, stacking a metal layer on an insulating plate or simply etching a metal layer to form an electric conductor circuit, and various metal-layered transcriptional bodies have been proposed for use in such processes.

There are some methods that use a metal-layered transcriptional material provided with a metal carrier that serves as a laminate for multi-layered wiring in a subcomposite (for example, see Patent Document 1). This is because a metal carrier is required to withstand high temperature and high pressure processing conditions in the process for forming a metal layer on an insulating plate.

On the other hand, those which do not require high temperature processing conditions for such transfer include antenna circuits and electromagnetic shielding plates (for example, see Patent Document 2) and in such cases, the use of resin film as the base is economical.

When transferring a metal film from a base to an insulating plate, it is necessary to form a stable peeling interface to ensure complete peeling of the metal film, and various solutions have been proposed. Commonly a releasing agent is fixed on a base to allow the interface between the metal film and the releasing agent to work as peeling interface and the known useful releasing agents include silicone-based releasing materials such as mixtures of an adhesive, e.g. polyvinyl formal, and silicone and mixtures of epoxy resin and silicone (see Patent Document 3) and those containing fluorine-based resin or polyolefin resin as releasing material (see Patent Document 4). Other proposed methods include the use of an oxide formed on the surface of a metal carrier (see Patent Document 5) and the use of a dissimilar metal as the release layer material (see Patent Document 6).

### Prior Art Documents

### Patent Documents

[Patent document 1] Japanese Unexamined Patent Publication (Kokai) No. 2001-62955
[Patent document 2] Japanese Unexamined Patent Publication (Kokai) No. 2006-42240
[Patent document 3] Japanese Unexamined Patent Publication (Kokai) No. HEI-5-185800
[Patent document 4] Japanese Unexamined Patent Publication (Kokai) No. 2004-230729
[Patent document 5] Japanese Unexamined Patent Publication (Kokai) No. 2003-181970
[Patent document 6] Japanese Unexamined Patent Publication (Kokai) No. 2009-90570

### Summary of the Invention

### Problems to be Solved by the Invention

When the technique described in Patent Document 3 given above is used, silicone may be transferred to the metal layer to form an oxide with insulation properties in subsequent steps, such as for heat treatment, after circuit formation, leading to the problem of reducing the conductivity. When using the technique described in Patent Document 4, fluorine transferred to the metal layer may cause corrosion of the metal layer.

An object of the present invention is to solve these problems and provide, in a highly economical, low-cost way, a laminate designed for transferring a metal layer to a circuit substrate in a clean state.

### Means of Solving the Problems

The present invention adopts the following constitution to achieve the object described above.
(1) A laminate including a base, a carbon layer composed mainly of carbon atoms, and a metal layer composed mainly of copper atoms, stacked in this order.
(2) A laminate as described in (1), wherein the base is a metal plate.
(3) A laminate as described in either (1) or (2), wherein the carbon layer is an amorphous carbon layer.
(4) A laminate as described in any one of (1) to (3), wherein N atoms account for 5% by atoms or less of the total number of atoms, which accounts for 100% by atoms, in the carbon layer.
(5) A laminate as described in any one of (1) to (4), wherein the carbon layer is one produced by sputtering while the metal layer is one produced by a vapor phase deposition method other than sputtering.
(6) A laminate as described in any one of (1) to (5), wherein the carbon layer and the metal layer are in contact with each other in the laminate.
(7) A laminate as described in any one of (1) to (6), wherein the carbon layer has a thickness of 0.005 to 10 µm.
(8) A laminate as described in any one of (1) to (7), wherein the metal layer has a thickness of 0.05 to 30 µm.

### Advantageous Effect of the Invention

The use of the laminate according to the present invention serves to produce metal parts of an electrode for a circuit board in a clean state and the laminate can be provided in a highly economical way.

### Brief Description of the Drawing

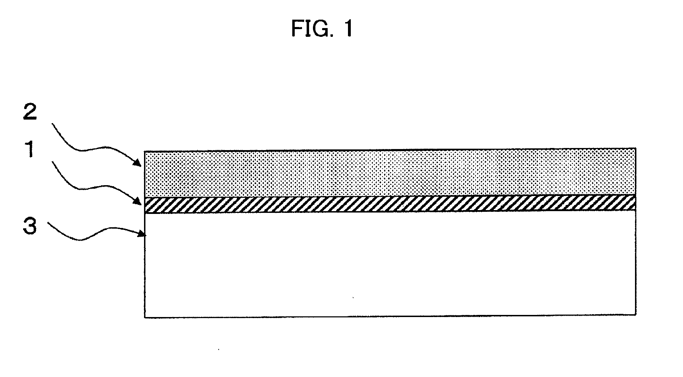

[Fig. 1] Fig. 1 is a schematic cross-sectional view of the laminate produced in Example 1 of the present invention.

### Description of Embodiments

An embodiment of the present invention is described below. The embodiment given here is merely an example and it should be understood that the invention is not construed as being limited thereto.

The laminate according to the embodiment of the present invention includes a base (A), a carbon layer (B) composed mainly of carbon atoms, and a metal layer (C) composed mainly of copper atoms, stacked in this order.

The base (A) is formed of such material as resin and metal. Hereinafter, a base made of a resin material is referred as a resin film and a base made of a metal material is referred as a metal plate. Any material will do to form the base (A) as long as it has a strength that is high enough to allow a carbon layer (B) composed mainly of carbon atoms to be formed between the base (A) and the metal layer (C), and an appropriate material may be selected as the base (A) depending on the transfer method and transfer conditions to be adopted for the metal layer (C). However, for the reasons which will be described later, the material of the base (A) is preferably a metal. That is, the base (A) is preferably a metal plate.

There are no specific limitations on the thickness of the base (A) unless it has a disadvantage for the transfer of the metal layer (C), but from the viewpoint of handleability and the necessity of supply in the form of a roll, it is preferably 5 to 500 µm. Creasing may occur undesirably during handling if the thickness of the base (A) is less than 5 µm while it may be difficult to wind up the product into a roll if it is more than 500 µm.

The carbon layer (B) composed mainly of carbon atoms referred to herein is one in which carbon atoms account for 95% by atoms or more and 100% by atoms or less of the total number of atoms, which accounts for 100% by atoms, in the layer (that is, the expression "composed mainly of carbon atoms" means that carbon atoms account for 95% by atoms or more and 100% by atoms or less of the total number of atoms, which accounts for 100% by atoms, in the layer).

There are no specific limitations on the state of the carbon atoms in the carbon layer (B) and they may be either in the form of organic carbon or inorganic carbon, but it is preferable for them to be in the form of inorganic carbon. If the carbon atoms in the carbon layer (B) are in the form of inorganic carbon, the metal layer (C) in the laminate can be peeled off smoothly without contaminating the metal layer (C) as it is transferred to another substrate.

In regard to the production method for the carbon layer (B), vapor phase deposition is preferred particularly when an inorganic carbon layer is to be formed as carbon layer (B). The available vapor phase deposition methods include CVD, ion plating, and sputtering, of which sputtering is the most preferable vapor phase deposition method. The use of the sputtering technique as the method for producing the carbon layer (C) is particularly preferable because the carbon layer (B) can be fixed firmly to the base (A) and the composition of the carbon layer (B) can be controlled easily.

The metal layer (C) composed mainly of copper atoms referred to herein is one in which copper atoms account for 50% by atoms or more and 100% by atoms or less of the total number of atoms, which accounts for 100% by atoms, in the layer (that is, the expression "composed mainly of copper atoms" means that copper atoms account for 50% by atoms or more and 100% by atoms or less of the total number of atoms, which accounts for 100% by atoms, in the layer).

There are no specific limitations on the surface electric resistance of the metal layer (C), but when a metal layer formed by transferring the metal layer (C) in the laminate according to the present embodiment is to be used in a circuit board, the surface electric resistance of the metal layer (C) is preferably less than 1 kΩ/sq. Furthermore, there are no specific requirements for its lower limit, but the practically reachable lower limit is thought to be about 0.001 Ω/ sq.

As long as it contains copper atoms as primary component, the metal layer (C) may be made of a copper-based alloy instead of pure copper.

The base (A) is preferably a metal plate. If a metal plate made of metal is used as the base (A), it can be pressed under high temperature, high pressure conditions and accordingly can be applied to a process for producing high density laminated circuit boards such as subcomposite. The metal materials suitable for a metal plate to be formed on the base (A) include, for example, copper, aluminum, nickel, molybdenum, and tungsten, and an appropriate one may be selected considering the transfer method and transfer conditions adopted for the metal layer (C).

If copper or aluminum is used as the metal to form the metal plate, they are preferable in view of the required cost and economics, but they are low in rupture strength and, particularly when the thickness of the metal plate is less than 50 µm, the plate may break during steps of, for example, processing to form the metal layer (C) and transferring the metal layer (C), possibly leading to difficult handling and low yield when pressing is performed under high pressure.

If molybdenum or tungsten is used as the metal to form the metal plate, the base (A) will be expensive, but their use is preferable because the plate will be so high in rupture strength that a higher pressure can be used for pressing in the step of transferring the metal layer (C) and in addition, the reduction in yield due to breakage of the base (A) etc. will be prevented. After the transfer of the metal layer (C), furthermore, the base (A) can be recovered for repeated use, ensuring economical and environment advantages.

The carbon layer (B) is preferably an amorphous carbon layer. Thus the carbon atoms in the carbon layer (B) is preferably in the form of inorganic carbon rather than organic carbon, and in particular, the carbon atoms in the carbon layer (B) are preferably in the form of amorphous carbon among other forms of inorganic carbon. Amorphous carbon refers to carbon-based materials having an amorphous structure instead of those having a regular structure such as diamond and graphite.

The structure formed by the carbon atoms in the carbon layer (B) can be determined by examining Raman spectra. Specifically, diamond (sp3 structure) gives a sharp Raman band near 1,333 cm⁻¹. Graphite with a perfect structure (sp2 structure) gives only one Raman band near 1,580 cm⁻¹, but another Raman band appears near 1,360 cm⁻¹ as the structure is disordered. Here, glassy carbon (GC, an amorphous carbon), which has an sp2 structure with a high degree of amorphousness, is referred to as amorphous carbon and it gives a considerably strong Raman band near 1,360 cm⁻¹ in addition to another one near 1,590 cm⁻¹, which together form two broad Raman bands. Amorphous carbon having an sp2 structure with a higher degree of amorphousness gives two very broad Raman bands near 1,590 cm⁻¹ and 1,360 cm⁻¹. Further, diamond-like carbon (DLC) film having both the sp3 structure and sp2 structure gives an asymmetric Raman band consisting of a primary peak (G band) near 1,540 cm⁻¹ and a shoulder peak (D band) near 1,390 cm⁻¹. All these Raman bands are attributed to sp2 carbon atoms, but the relative intensities of the Raman bands are thought to have close relations with the sp3-related properties of the carbon film.

Thus, if Raman spectroscopic analysis of the carbon layer (B) gives two broad Raman bands near 1,360 cm⁻¹ and 1,590 cm⁻¹, it means that the carbon layer (B) in the laminate according to the present embodiment is an amorphous carbon layer (indicating that the carbon atoms in the carbon layer (B) are in the form of amorphous carbon).

A carbon layer (B) in the form of an amorphous carbon layer can be produced by such methods as ion beam deposition and sputtering using a carbon target, of which the use of sputtering is preferred as described above. For the sputtering process, furthermore, it is preferable that hydrogen, methane, carbon monoxide, carbon dioxide, nitrogen, oxygen, or a mixed gas thereof be used as an additional reactant gas together with Ar because the film formation speed may be increased as a result of their chemical vapor phase etching effect on the sputtering phenomenon at the target surface.

The carbon layer (B) preferably contains N (nitrogen) atoms at a content of 5% by atoms or less of all atoms, which account for 100% by atoms, in the carbon layer (B). To add N atoms to a carbon layer, a nitrogen-containing gas may be adopted as the introducing gas used to generate plasma for sputtering. The addition of N atoms to the carbon layer (B) can be achieved either by using nitrogen gas alone as introducing gas or using a mixture of argon gas and nitrogen gas as introducing gas. From the viewpoint of ensuring stable plasma generation, however, it is preferable that a mixture of argon gas and nitrogen gas, which is low in discharge voltage, be used in the sputtering step of the carbon layer (B) production process with the aim of allowing the N (nitrogen) atoms to account for 5% by atoms or less of the total number of atoms, which account for 100% by atoms, in the carbon layer (B).

In the carbon layer (B) thus formed, the N atoms exist in the form of nitrogenized carbon. Here, some N atoms may be taken in the carbon layer (B) in the form of residual air left after evacuation. If the N atoms in the carbon layer (B) account for more than 5% by atoms of all (100%) atoms, the required peel force for peeling the metal layer (C) may increase due to, for example, an increased proportion of nitrogenized carbon, possibly allowing part of the metal layer (C) to remain in the carbon layer (B) after the peeling step.

There is no specific lower limit to the proportion of the N atoms to all atoms in the carbon layer (B), but it is preferable for the N atoms to account for 0.1% by atoms or more of all atoms in the carbon layer (B). Thus, an amorphous carbon structure is expected to be formed stably in the carbon layer (B) when the N atoms account for 0.1% by atoms to 5% by atoms in the carbon layer (B), and this is preferable because the metal layer (C) will not be left in the carbon layer (B) in the metal layer (C) peeling step. The content is more preferably 1% by atoms to 4% by atoms and still more preferably 3% by atoms to 4% by atoms from the viewpoint of peelability.

For the laminate according to the present embodiment, the carbon layer (B) is preferably one produced by sputtering while the metal layer (C) is one produced by a vapor phase deposition method other than sputtering. The use of sputtering to form the carbon layer (B) serves to bring the carbon layer (B) into firm contact with the base (A) and accordingly prevent the carbon layer (B) to be partially attached to the metal layer (C) in the transfer step. Since the metal layer (C) formed on the carbon layer (B) should be transferred to an adherend such as insulating substrate in the transfer step without remaining on the carbon layer (B) and therefore strong contact between the carbon layer (B) and the metal layer (C) is not preferable because a large peeling force will be required in the transfer step. Thus, a vapor phase deposition method other than sputtering is preferably used to form the metal layer (C) in order to ensure relatively weak contact between the carbon layer (B) and the metal layer (C) whereas strong contact is maintained between the carbon layer (B) and the base (A). The available vapor phase deposition methods other than sputtering include vacuum deposition (induction heating type, electron beam heating type), pulse laser deposition, chemical vapor deposition (CVD), and metal organic chemical vapor deposition (MOCVD). When a sheet-like, long-sized resin film is used as the base (A), the metal layer (C) can be formed by a roll-to-roll type vacuum deposition method. This is preferable from the viewpoint of productivity because in that case, continuous film formation can be performed through connected low pressure chambers if the ambient pressure for the production of the carbon layer (B) is nearly the same as that of the metal layer (C) or if the ambient pressure for the production of the carbon layer (C) is lower. This is preferable also because continuous film formation of the carbon layer (B) and the metal layer (C) in connected low pressure chambers serves to control the abrasion of the metal layer (C) and its deterioration by oxidation etc. If vacuum deposition is adopted as the production method for the metal layer (C), the peel strength required for removing the metal layer (C) from the carbon layer (B) will be reduced and the peeling between the carbon layer (B) and the metal layer (C) can be performed smoothly in the transfer step without mixing between them.

For the present embodiment, it is preferable that the carbon layer (B) and the metal layer (C) be stacked in contact with each other. This means that in the laminate according to the present embodiment, it is preferable that no other layers exist between the carbon layer (B) and the metal layer (C). Since the present invention is based on the fact that carbon and copper make relatively weak contact, it is preferable that the carbon layer (B) and the metal layer (C) have a large interface area where they are in direct contact, which leads to reduction in the required peeling force.

The thickness of the carbon layer (B) is preferably 0.005 to 10 µm. If the thickness of the carbon layer (B) is less than 0.005 µm, it will be difficult to form the carbon layer (B) uniformly over the surface of the base (A), possibly causing partial exposure of the base (A). That part of the metal layer (C) which is formed on an exposed part of the base (A) will possibly be difficult to peel. The carbon layer (B) is only required to serve for preventing the base (A) and the metal layer (C) from coming into direct contact with each other and, from an economical point of view, it is required to have a thickness of 10 µm at most.

The thickness of the metal layer (C) is preferably 0.05 to 30 µm. If the thickness of the metal layer (C) is less than 0.05 µm, the layer may be low in handleability due to breakage and wrinkling when it is transferred to a circuit board etc. If the metal layer (C) has to have a thickness of more than 30 µm, the use of a commercially available metal foil may be more economical.

As a preferable example, the metal layer (C) in the laminate according to the present embodiment may have a patterned shape when resin film is used as the base (A). The laminate according to the present embodiment is suitably used to produce an electrode or circuit by transferring a complicated pattern formed on the base (A). Therefore, if the metal layer (C) is originally formed in a patterned shape, it can be suitably applied finally to the production of an electrode or circuit. Here, there are no specific limitations on the pattern, and preferable ones include mesh-like and stripe. Methods such as photoresist etching may be used to produce a metal layer (C) in a patterned shape.

### Examples

The present invention will now be illustrated in more detail with reference to examples, but it should be understood that the invention is not construed as being limited to these examples. The methods used for the evaluation of samples prepared in the examples are as described below.

### (1) Measurement of thickness of carbon layer and metal layer

A section is prepared using a microtome from each sample prepared and cross-sectional observation is performed by a field emission-type scanning electron microscope (JSM-6700F, manufactured by JEOL Ltd., accelerating voltage 10 kV, magnification 20,000) to determine the thickness of the carbon layer and metal layer. For a 20 cm x 20 cm sample, measurements were made at five arbitrarily selected positions and their average was taken to represent the layer thickness.

### (2) Confirmation of the contents (% by atoms) of C (carbon) and N (nitrogen) atoms in carbon layer and the composition of metal layer containing copper atom as primary component

A 3 mm x 3 mm piece is cut out of a 50 mm x 50 mm specimen and observed by ESCA-1000 manufactured by Shimadzu Corporation. The content (% by atoms) of C (carbon) and N (nitrogen) atoms in the carbon layer is determined by observing a metal-layer-free laminate consisting of a base and a carbon layer from the carbon layer side. On the other hand, the composition of the metal layer containing copper atoms as primary component is determined by observing a laminate consisting of a base, carbon layer, and metal-layer from the metal layer side.

The measuring conditions used were as described below.
Light source: Mg/Al
Accelerating voltage: 10 kV
Accelerating current: 10 mA
Resolution: 31.5 eV

### (3) Analysis of structure of carbon atoms in carbon layer (Raman spectroscopic analysis)

A 3 mm x 3 mm piece is cut out of a 50 mm x 50 mm specimen and observed from the carbon layer side by PDP320 manufactured by Photo Design.

Raman spectroscopy was performed under the following measuring conditions and difference spectrum measurements were analyzed.

### Measurement mode; micro-Raman spectroscopy

Objective lens: x90
Beam diameter: 1 µm
Cross slit: 100 µm
Light source: Ar+ laser
Laser power: 6 mW
Diffraction grating: 600 gr/mm
Slit: 100 µm
Detector: OCD/Roper Scientific

### (4) Measurement of peeling force (evaluation of releasability)

A 50 mm x 50 mm specimen was pasted on a 100 mm x 100 mm glass plate with a thickness of 5 mm with a No. 500 double sided tape manufactured by Nitto Denko Corporation in such a way that the metal layer was exposed and that the base was in contact with the glass plate. A piece of No. 405 Cellotape (registered trademark) (with a width of 18 mm) manufactured by Nichiban Co., Ltd. was attached to the surface of the metal layer of the specimen pasted above and a cut is made in the metal layer in the width direction of the Cellotape. An end is slightly peeled off and then pulled up by a spring scale while measuring the force required to remove it (peel force).

The releasability was evaluated and the specimen was ranked as acceptable (○) when the peel force was 20 g or less or unacceptable (x) when it was more than 20 g or when part of the metal layer remained unpeeled from the specimen surface.

### (Example 1)

A molybdenum sheet (with a thickness of 100 µm) manufactured by Toshiba Materials Co., Ltd. was used as the base (A). A 100 mm x 100 mm piece was cut out to provide a specimen.

A carbon layer (B) was formed by sputtering on one side of the base (A) (molybdenum sheet) by a batch type sputtering apparatus. A flow of nitrogen gas with a purity of 100% by atoms was used as introducing gas and it was controlled and introduced under the following conditions: the ultimate pressure was 0.03 Pa and the pressure in the apparatus was 0.5 Pa. A carbon target (56 mm x 106 mm x 5 mm) was connected to a DC power source and sputtering was performed at 88 W for 2 minutes. Two such specimens were prepared and one of them was set aside for evaluation.

On the carbon layer (B) of the other one, copper was deposited by a batch type deposition apparatus to form a metal layer (C). This was carried out under the following conditions: the ultimate pressure was 0.02 Pa; 5 g of copper was put on a tungsten board with a thickness of 0.3 mm; and the deposition current and time were 200 A and 3 minutes, respectively.

Atomic concentrations in the carbon layer (B) in the specimen for evaluation were measured and results showed that the contents of N and C were 5% by atoms and 95% by atoms, respectively. When the carbon layer (B) was analyzed by Raman spectroscopy, two broad Raman bands were observed near 1,590 cm⁻¹ and 1,360 cm⁻¹, indicating that an amorphous carbon layer had been formed.

The specimen with deposited copper was examined to determine the thickness of each layer and results showed that the carbon layer (B) had a thickness of 0.02 µm. The metal layer (C) had a thickness of 2 µm. Peel force examination showed that the copper deposited film was removed completely by a force of 7 g and the peelability was judged as acceptable (○). It was found that the metal layer (C) contained copper atoms at a content in the range of 50% by atoms or more and 100% by atoms or less of all atoms (100% by atoms) in the layer.

### (Example 2)

As in Example 1, a molybdenum sheet (with a thickness of 100 µm) manufactured by Toshiba Materials Co., Ltd. was used as the base (A). A 100 mm x 100 mm piece was cut out to provide a specimen.

A carbon layer (B) was formed by sputtering on one side of the base (A) (molybdenum sheet) by a batch type sputtering apparatus. A flow of a mixed gas consisting of 50% by atoms of argon and 50% by atoms of nitrogen was used as introducing gas and it was controlled and introduced under the following conditions: the ultimate pressure was 0.03 Pa and the pressure in the apparatus was 0.5 Pa. The use of a mixed gas allows the control of the stability of sputtering and that is way argon gas, which is high in electric dischargeability, was mixed in. A carbon target (56 mm x 106 mm x 5 mm) was connected to a DC power source and sputtering was performed at 80 W for 2 minutes. Two such specimens were prepared and one of them was set aside for evaluation.

On the carbon layer (B) of the other one, copper was deposited by a batch type deposition apparatus to form a metal layer (C). This was carried out under the following conditions: the ultimate pressure was 0.02 Pa; 5 g of copper was put on a tungsten board with a thickness of 0.3 mm; and the deposition current and time were 200 A and 3 minutes, respectively.

Atomic concentrations in the carbon layer (B) in the specimen for evaluation were measured and results showed that the contents of N and C were 3% by atoms and 97% by atoms, respectively. When the carbon layer (B) was analyzed by Raman spectroscopy, two broad Raman bands were observed near 1,590 cm⁻¹ and 1,360 cm⁻¹, indicating that an amorphous carbon layer had been formed.

The specimen with deposited copper was examined to determine the thickness of each layer and results showed that the carbon layer (B) had a thickness of 0.01 µm. The metal layer (C) had a thickness of 2 µm. Peel force examination showed that the copper deposited film was removed completely by a force of 5 g and the peelability was judged as acceptable (○). It was found that the metal layer (C) contained copper atoms at a content in the range of 50% by atoms or more and 100% by atoms or less of all atoms (100% by atoms) in the layer.

### (Example 3)

As in Example 1, a molybdenum sheet (with a thickness of 100 µm) manufactured by Toshiba Materials Co., Ltd. was used as the base (A). A 100 mm x 100 mm piece was cut out to provide a specimen.

A carbon layer (B) was formed by sputtering on one side of the base (A) by a batch type sputtering apparatus. A flow of a mixed gas consisting of 50% by atoms of argon and 50% by atoms of nitrogen was used as introducing gas and it was controlled and introduced under the following conditions: the ultimate pressure was 0.03 Pa and the pressure in the apparatus was 0.5 Pa. A carbon target (56 mm x 106 mm x 5 mm) was connected to a DC power source and sputtering was performed at 80 W for 4 minutes. Two such specimens were prepared and one of them was set aside for evaluation.

On the carbon layer (B) of the other one, copper was deposited by a batch type deposition apparatus to form a metal layer (C). This was carried out under the following conditions: the ultimate pressure was 0.02 Pa; 5 g of copper was put on a tungsten board with a thickness of 0.3 mm; and the deposition current and time were 200 A and 3 minutes, respectively.

Atomic concentrations in the carbon layer (B) in the specimen for evaluation were measured and results showed that the contents of N and C were 3% by atoms and 97% by atoms, respectively. When the carbon layer (B) was analyzed by Raman spectroscopy, two broad Raman bands were observed near 1,590 cm⁻¹ and 1,360 cm⁻¹, indicating that an amorphous carbon layer had been formed.

The specimen with deposited copper was examined to determine the thickness of each layer and results showed that the carbon layer (B) had a thickness of 0.02 µm. The metal layer (C) had a thickness of 2 µm. Peel force examination showed that the copper deposited film was removed completely by a force of 2 g and the peelability was judged as acceptable (○). It was found that the metal layer (C) contained copper atoms at a content in the range of 50% by atoms or more and 100% by atoms or less of all atoms (100% by atoms) in the layer.

### (Example 4)

As in Example 1, a molybdenum sheet (with a thickness of 100 µm) manufactured by Toshiba Materials Co., Ltd. was used as the base (A). A 100 mm x 100 mm piece was cut out to provide a specimen.

A carbon layer (B) was formed by sputtering on one side of the base (A) by a batch type sputtering apparatus. A flow of argon gas with a purity of 100% by atoms was used as introducing gas and it was controlled and introduced under the following conditions: the ultimate pressure was 0.03 Pa and the pressure in the apparatus was 0.5 Pa. A carbon target (56 mm x 106 mm x 5 mm) was connected to a DC power source and sputtering was performed at 80 W for 2 minutes. Two such specimens were prepared and one of them was set aside for evaluation.

On the carbon layer (B) of the other one, copper was deposited by a batch type deposition apparatus to form a metal layer (C). This was carried out under the following conditions: the ultimate pressure was 0.02 Pa; 5 g of copper was put on a tungsten board with a thickness of 0.3 mm; and the deposition current and time were 200 A and 3 minutes, respectively.

Atomic concentrations in the carbon layer (B) in the specimen for evaluation were measured and results showed that N was not contained and that the content of C was 99% by atoms. When the carbon layer (B) was analyzed by Raman spectroscopy, two broad Raman bands were observed near 1,590 cm⁻¹ and 1,360 cm⁻¹, indicating that an amorphous carbon layer had been formed.

The specimen with deposited copper was examined to determine the thickness of each layer and results showed that the carbon layer (B) had a thickness of 0.02 µm. The metal layer (C) had a thickness of 2 µm. Peel force examination showed that the copper deposited film was removed completely by a force of 7 g and the peelability was judged as acceptable (○). It was found that the metal layer (C) contained copper atoms at a content in the range of 50% by atoms or more and 100% by atoms or less of all atoms (100% by atoms) in the layer.

### (Example 5)

As in Example 1, a molybdenum sheet (with a thickness of 100 µm) manufactured by Toshiba Materials Co., Ltd. was used as the base (A). A 100 mm x 100 mm piece was cut out to provide a specimen.

On one side of the base (A), a graphite paint (Black Lube (registered trademark), manufactured by Audec Corporation) was sprayed for 2 seconds and calcined at 450°C for 10 seconds in a muffle furnace to form a carbon film (B). Two such specimens were prepared and one of them was set aside for evaluation.

On the carbon layer (B) of the other one, copper was deposited by a batch type deposition apparatus to form a metal layer (C). This was carried out under the following conditions: the ultimate pressure was 0.02 Pa; 5 g of copper was put on a tungsten board with a thickness of 0.3 mm; and the deposition current and time were 200 A and 3 minutes, respectively.

Atomic concentrations in the carbon layer (B) in the specimen for evaluation were measured and results showed that N was not contained and that the content of C was 99% by atoms. When the carbon layer (B) was analyzed by Raman spectroscopy, only one Raman band was observed near 1,590 cm⁻¹, indicating that graphite-like carbon had been formed.

The specimen with deposited copper was examined to determine the thickness of each layer and results showed that the carbon layer (B) had a thickness of 0.2 µm. The metal layer (C) had a thickness of 2 µm. Peel force examination showed that the copper deposited film was removed completely by a force of 10 g and the peelability was judged as acceptable (○). It was found that the metal layer (C) contained copper atoms at a content in the range of 50% by atoms or more and 100% by atoms or less of all atoms (100% by atoms) in the layer.

### (Example 6)

As in Example 1, a molybdenum sheet (with a thickness of 100 µm) manufactured by Toshiba Materials Co., Ltd. was used as the base (A). A 100 mm x 100 mm piece was cut out to provide a specimen.

A carbon layer (B) was formed by sputtering on one side of the base (A) (molybdenum sheet) by a batch type sputtering apparatus. A flow of a mixed gas consisting of 40% by atoms of argon and 60% by atoms of nitrogen was used as introducing gas and it was controlled and introduced under the following conditions: the ultimate pressure was 0.03 Pa and the pressure in the apparatus was 0.5 Pa. The use of a mixed gas allows the control of the stability of sputtering and that is way argon gas, which is high in electric dischargeability, was mixed in. A carbon target (56 mm x 106 mm x 5 mm) was connected to a DC power source and sputtering was performed at 88 W for 2 minutes. Two such specimens were prepared and one of them was set aside for evaluation.

On the carbon layer (B) of the other one, copper was deposited by a batch type deposition apparatus to form a metal layer (C). This was carried out under the following conditions: the ultimate pressure was 0.02 Pa; 5 g of copper was put on a tungsten board with a thickness of 0.3 mm; and the deposition current and time were 200 A and 3 minutes, respectively.

Atomic concentrations in the carbon layer (B) in the specimen for evaluation were measured and results showed that the contents of N and C were 0.1% by atoms and 99.9% by atoms, respectively. When the carbon layer (B) was analyzed by Raman spectroscopy, two broad Raman bands were observed near 1,590 cm⁻¹ and 1,360 cm⁻¹, indicating that an amorphous carbon layer had been formed.

The specimen with deposited copper was examined to determine the thickness of each layer and results showed that the carbon layer (B) had a thickness of 0.01 µm. The metal layer (C) had a thickness of 2 µm. Peel force examination showed that the copper deposited film was removed completely by a force of 3 g and the peelability was judged as acceptable (○). It was found that the metal layer (C) contained copper atoms at a content in the range of 50% by atoms or more and 100% by atoms or less of all atoms (100% by atoms) in the layer.

### (Example 7)

As in Example 1, a molybdenum sheet (with a thickness of 100 µm) manufactured by Toshiba Materials Co., Ltd. was used as the base (A). A 100 mm x 100 mm piece was cut out to provide a specimen.

A carbon layer (B) was formed by sputtering on one side of the base (A) (molybdenum sheet) by a batch type sputtering apparatus. A flow of a mixed gas consisting of 90% by atoms of argon and 10% by atoms of nitrogen was used as introducing gas and it was controlled and introduced under the following conditions: the ultimate pressure was 0.03 Pa and the pressure in the apparatus was 0.5 Pa. The use of a mixed gas allows the control of the stability of sputtering and that is way argon gas, which is high in electric dischargeability, was mixed in. A carbon target (56 mm x 106 mm x 5 mm) was connected to a DC power source and sputtering was performed at 88 W for 2 minutes. Two such specimens were prepared and one of them was set aside for evaluation.

On the carbon layer (B) of the other one, copper was deposited by a batch type deposition apparatus to form a metal layer (C). This was carried out under the following conditions: the ultimate pressure was 0.02 Pa; 5 g of copper was put on a tungsten board with a thickness of 0.3 mm; and the deposition current and time were 200 A and 3 minutes, respectively.

Atomic concentrations in the carbon layer (B) in the specimen for evaluation were measured and results showed that the contents of N and C were 0.1% by atoms and 99.9% by atoms, respectively. When the carbon layer (B) was analyzed by Raman spectroscopy, two broad Raman bands were observed near 1,590 cm⁻¹ and 1,360 cm⁻¹, indicating that an amorphous carbon layer had been formed.

The specimen with deposited copper was examined to determine the thickness of each layer and results showed that the carbon layer (B) had a thickness of 0.01 µm. The metal layer (C) had a thickness of 2 µm. Peel force examination showed that the copper deposited film was removed completely by a force of 6 g and the peelability was judged as acceptable (○). It was found that the metal layer (C) contained copper atoms at a content in the range of 50% by atoms or more and 100% by atoms or less of all atoms (100% by atoms) in the layer.

### (Example 8)

As in Example 1, a molybdenum sheet (with a thickness of 100 µm) manufactured by Toshiba Materials Co., Ltd. was used as the base (A). A 100 mm x 100 mm piece was cut out to provide a specimen.

A carbon layer (B) was formed by sputtering on one side of the base (A) (molybdenum sheet) by a batch type sputtering apparatus. A flow of a mixed gas consisting of 15% by atoms of argon and 85% by atoms of nitrogen was used as introducing gas and it was controlled and introduced under the following conditions: the ultimate pressure was 0.03 Pa and the pressure in the apparatus was 0.5 Pa. The use of a mixed gas allows the control of the stability of sputtering and that is way argon gas, which is high in electric dischargeability, was mixed in. A carbon target (56 mm x 106 mm x 5 mm) was connected to a DC power source and sputtering was performed at 90 W for 2 minutes. Two such specimens were prepared and one of them was set aside for evaluation.

On the carbon layer (B) of the other one, copper was deposited by a batch type deposition apparatus to form a metal layer (C). This was carried out under the following conditions: the ultimate pressure was 0.02 Pa; 5 g of copper was put on a tungsten board with a thickness of 0.3 mm; and the deposition current and time were 200 A and 3 minutes, respectively.

Atomic concentrations in the carbon layer (B) in the specimen for evaluation were measured and results showed that the contents of N and C were 7% by atoms and 99.9% by atoms, respectively. When the carbon layer (B) was analyzed by Raman spectroscopy, two broad Raman bands were observed near 1,590 cm⁻¹ and 1,360 cm⁻¹, indicating that an amorphous carbon layer had been formed.

The specimen with deposited copper was examined to determine the thickness of each layer and results showed that the carbon layer (B) had a thickness of 0.01 µm. The metal layer (C) had a thickness of 2 µm. The peel force was measured and found to be 12 g. The peelability was judged as acceptable (○), but peeling was more difficult to perform than in Examples 1 to 6. It was found that the metal layer (C) contained copper atoms at a content in the range of 50% by atoms or more and 100% by atoms or less of all atoms (100% by atoms) in the layer.

### (Comparative example 1)

A molybdenum sheet (with a thickness of 100 µm) manufactured by Toshiba Materials Co., Ltd. was used as the base (A). A 100 mm x 100 mm piece was cut out to provide a specimen.

A metal layer was formed on one side of the base (A) (molybdenum sheet) by depositing copper using a batch type deposition apparatus. This was carried out under the following conditions: the ultimate pressure was 0.02 Pa; 5 g of copper was put on a tungsten board with a thickness of 0.3 mm; and the deposition current and time were 200 A and 3 minutes, respectively.

When a new molybdenum sheet was analyzed by Raman spectroscopy, only molybdenum-derived Raman bands were observed, indicating that amorphous carbon was not contained.

A specimen was prepared and subjected to copper layer thickness measurement by TEM, showing that the thickness was 2 µm. The peel force was measured and judged as unacceptable (x) because the copper layer was removed unevenly when pulled by a force of 100 g, indicating that it would not work effectively in an electrode (that is, this specimen fell into the case where the required peel force is more than 20 g and also fell into the case where part of the metal layer remained unpeeled from the specimen surface, and accordingly the peelability was judged as unacceptable).

[Table 1]

**[Table 1]**

| No. | Base | Carbon film formation method | Sputtering gas composition (pressure: 0.5Pa constant) | Electric power [W] | Carbon layer | | | Metal layer | Releasability evaluation (measured peel force) *Smaller peel force is more preferable |
|---|---|---|---|---|---|---|---|---|---|
| | | | | | film formation time [min] | thickness [µm] | Content of N atoms [% by atoms] | thickness [µm] | |
| Example 1 | 100 µm thick molybdenum sheet | sputtering | N₂ 100% by atoms | 88 | 2 | 0.02 | 5 | 2 | ○ (7g) |
| Example 2 | 100 µm thick molybdenum sheet | sputtering | Ar 50% by atoms + N₂ 50% by atoms | 80 | 2 | 0.01 | 3 | 2 | ○ (5g) |
| Example 3 | 100 µm thick molybdenum sheet | sputtering | Ar 50% by atoms + N₂ 50% by atoms | 80 | 4 | 0.02 | 3 | 2 | ○ (2g) |
| Example 4 | 100 µm thick molybdenum sheet | sputtering | Ar 100% by atoms | 80 | 2 | 0.02 | 0 | 2 | ○ (7g) |
| Example 5 | 100 µm thick molybdenum sheet | spray/calcine | - | - | - | 0.2 | 0 | 2 | ○ (10g) |
| Example 6 | 100 µm thick molybdenum sheet | sputtering | Ar 40% by atoms + N₂ 60% by atoms | 88 | 2 | 0.01 | 4 | 2 | ○ (3g) |
| Example 7 | 100 µm thick molybdenum sheet | sputtering | Ar 90% by atoms + N₂ 10% by atoms | 88 | 2 | 0.01 | 0.1 | 2 | ○ (6g) |
| Example 8 | 100 µm thick molybdenum sheet | sputtering | Ar 15% by atoms + N₂ 85% by atoms | 90 | 2 | 0.01 | 7 | 2 | ○ (12g) |
| Comparative example 1 | 100 µm thick molybdenum sheet | - | free of carbon | - | - | - | - | 2 | x (Peel force of more than 20 g was required and part of metal layer remained unpeeled from specimen surface.) |

### Industrial Applicability

The present invention provides a metal release material suitable for forming electrodes and circuits by transferring the metal and particularly preferable for use in processes in which a metal layer having a pattern of an electrode or circuit is formed and then transferred. It should be noted, however, that the scope of the invention is not limited to these applications.

### Explanation of Numerals

1. Carbon layer (B)
2. Metal layer (C)
3. Base (A)

## Claims

1. A laminate comprising a base, a carbon layer composed mainly of carbon atoms, and a metal layer composed mainly of copper atoms, stacked in this order.

2. A laminate as described in claim 1, wherein the base is a metal plate.

3. A laminate as described in either claim 1 or 2, wherein the carbon layer is an amorphous carbon layer.

4. A laminate as described in any one of claims 1 to 3, wherein N atoms account for 5% by atoms or less of the total number of atoms, which accounts for 100% by atoms, in the carbon layer.

5. A laminate as described in any one of claims 1 to 4, wherein the carbon layer is one produced by sputtering whereas the metal layer is one produced by a vapor phase deposition method other than sputtering.

6. A laminate as described in any one of claims 1 to 5, wherein the carbon layer and the metal layer are in contact with each other in the laminate.

7. A laminate as described in any one of claims 1 to 6, wherein the carbon layer has a thickness of 0.005 to 10 µm.

8. A laminate as described in any one of claims 1 to 7, wherein the metal layer has a thickness of 0.05 to 30 µm.
